# EUROPEAN PATENT SPECIFICATION

(11) **EP 2 657 157 B1**
(45) Date of publication and mention of the grant of the patent: **26.09.2018**
(21) Application number: 11849946.6
(22) Date of filing: 22.12.2011
(51) Int. Cl.: B65G 1/06, B65G 1/00, B65G 25/00, B65G 59/06, H05K 13/02, H05K 13/04

(54) **COMPONENT HOUSING STICK REPLACEMENT DEVICE AND COMPONENT HOUSING STICK REPLACEMENT METHOD**
VORRICHTUNG UND VERFAHREN FÜR DEN STIFTERSATZ BEI EINEM KOMPONENTENGEHÄUSE
DISPOSITIF ET PROCÉDÉ DE REMPLACEMENT DE TIGE DE STOCKAGE DE COMPOSANTS

(30) Priority: 24.12.2010 JP 2010288337
(43) Date of publication of application: 30.10.2013
(73) Proprietor: Yazaki Corporation, Minato-ku Tokyo 108-8333 (JP)
(72) Inventor: TSUCHIYA, Takayuki, Makinohara-shi Shizuoka 421-0407 (JP); KATSUYAMA, Hiroaki, Makinohara-shi Shizuoka 421-0407 (JP); KAWAI, Toshio, Toyohashi-shi Aichi 440-0832 (JP)
(74) Representative: Grünecker Patent- und Rechtsanwälte PartG mbB
(86) International application number: PCT/JP2011/079801
(87) International publication number: WO 2012/086752

(56) References cited:
- EP-A2- 0 498 394
- DE-A1- 3 533 572
- JP-A- 4 256 613
- JP-A- 5 162 844
- JP-A- 11 020 932
- JP-A- 50 098 429
- JP-A- 56 037 929
- JP-A- 63 106 216
- JP-A- S63 106 216
- JP-A- S63 202 520
- US-A- 4 950 120

## Description

### TECHNICAL FIRLD

The present invention relates to a component storage stick replacement device and a method for replacement of component storage stick arranged for stacking sticks containing components such as a connector housing in a plurality of tiers, supplying the components from the stick at the lowermost tier and replacing the lower stick which became empty with the upper stick.

### BACKGROUND ART

Conventionally, various component supply devices have been proposed for supplying a component such as an electronic component and a connector to the next step in the process.

For example, Patent Literature 1 discloses a component supply device having a tube stock portion having the tubes (sticks) containing a plurality of same-shaped connectors arranged in a plurality of tiers and the tubes (sticks) containing a plurality of different kind connectors arranged in a plurality of rows. The device is arranged to open the slit on a front wall at a location of the lowermost desired tube, transfer the desired connector from the desired tube to a receiving pallet by air pressure at the back, and move the receiving pallet along a horizontal rail to the next step which is the electric wire bonding step.

Furthermore, Patent Literature 2 discloses a component supply device having the rectangular tube-shaped stick which is provided with an inner face having a projection for reducing the friction and which is tilted forward towards the front horizontal printed substrate, wherein a small transformer as an electronic component is inserted into the stick from the rear side and supplied onto the printed substrate by air pressure.

### CITATION LIST

### Patent Literatures

Patent Literature 1: Japan Patent Application Publication No. 2007-1756 (Fig. 1)
Patent Literature 2: Japan Patent Application Publication No. H10-224083 (Fig. 1)

EP 0498 394 A2 relates to a component feeder for feeding components (8) from a tube magazine (2) comprises a pusher (44) on the end of a flexible steel tape (48) which extends from a tape housing (52). A filled tube (2) is supported on retractable pins (30, 30') in alignment with the pusher (44) and in alignment with a pickup station. The tape (48) is fed by feed rolls (50) so that the pusher (44) moves through the tube magazine (2) and feeds the components (8) along a guide track (36) to the pickup station. When the tube supported on pins (30, 30') is empty, the pusher (44) is retracted to its housing, the pins (30, 30') are retracted, and the empty tube falls on a conveyor belt (88) which carries it from the machine. A full tube (2) is then dropped onto the pins (30, 30') by a further pair of pins (32, 32') and (34, 34') which are moved between extended and retracted positions to control the movement of the filled tube which is supplied from an inventory of filled tubes supported on the pins (32, 32').

JP S63 202520 A relates to an empty stick collecting device. When a holding mechanism 6 confirms an empty stick 1a, it is sopped under its feeding line. And, holding claws 61, 61 are lifted up while being opened to hold the empty stick 1a. Then, a sliding body 63 is moved to the position of the dashed line, to move the empty stick 1a by a slight dimension I₁ at the opening of a magazine 5. Thereby, the lower course end of the empty stick 1a comes off of the opening and lowered removing the empty stick 1a from the magazine 5. Then, by lowering the claws 61, 61 while restoring the sliding body 63, the empty stick 1a is held in an inclined condition on an pin 68. And, the holding claws 61, 61 are moved to an unshown inclined discharging board to release the holding. Thereby, the empty sticks can be collected in one place saving a space.

### SUMMARY OF INVENTION

### Problem to be Solved

However, in the component supply device disclosed in Patent Literature 1 mentioned above, the tubes (sticks) for supplying the connector are arranged in the plurality of tiers, and when the tube at the lowermost tier becomes empty, the upper tube is moved to the lowermost tier by a worker by manually taking out the tube at the lowermost tier to the back, for example. Thus, the replacement of the tube is messy, decreasing the efficiency of the component supply.

In view of the above-mentioned drawback, an object of the present invention is to provide a component storage stick replacement device and a method for replacement of component storage stick which can efficiently replace a stick which is fished with supplying a component with a stick containing a component.

### Solution to Problem

In order to achieve the above-described object, the present invention provides, in a first aspect, a component storage stick replacement device including: a frame arranged to house a plurality of tiers of sticks containing components and having an empty stick elimination space located at a lower portion of the frame; a holding unit arranged to hold the respective sticks in a plurality of tiers within the frame; characterized in that a lifting-and-lowering unit is arranged to move the respective sticks in the plurality of tiers down one tier together with the holding unit and to move the holding unit up one tier separately from the respective sticks to return the holding unit to an original position; a drive unit is arranged to operate the holding unit to hold and release the respective sticks; and an another holding unit is arranged to hold the sticks other than the stick at the lowermost tier at least during the release.

According to the structure described above, the sticks containing the components are housed in the frame in the plurality of tiers, the respective sticks are held in the plurality of tiers in the frame by the holding unit, the component in the stick at the lowermost tier is supplied to the component supply passage, and after (at the time when) the stick at the lowermost tier becomes empty, the respective sticks in the plurality of tiers are moved down one tier together with the holding unit by the lifting-and-lowering unit, and the stick at the second tier from the bottom is positioned at (arranged continuous with) the component supply passage so that the component in the stick at the second tier from the bottom can be supplied. The sticks at the second tier and above from the bottom (including the second tier) are supported by the another holding unit. By releasing the hold by the holding unit using the drive unit, the stick at the lowermost tier drops into the lower space of the frame, and then the holding unit is moved up one tier by the lifting-and-lowering unit and returned to its original position. After that, this cycle is performed until there is no stick with the component (until the stick at the uppermost tier is dropped).

The present invention provides, in a second aspect, the component storage stick replacement device according to the first aspect, wherein the holding unit is a plurality of laterally-arranged pins fixed to a longitudinally-arranged shaft and arranged on top and bottom of each of the sticks, the shaft being arranged to rotate together with the respective pins by the drive unit.

According to the structure described above, the pins are arranged in contact with or adjacent to the top and bottom of the stick, thus the lower pin supports the stick while preventing the stick from dropping, and the upper pin pushes the stick down when moved down by the lifting-and-lowering unit. Integrally with the shaft, the respective pins are rotated in one direction and contacted with or positioned adjacent to the stick, and rotated in the other direction to separate from the stick. During the separation, the another holding unit prevents the stick from dropping. Preferably, the respective pins are provided in a pair (the shaft is provided in a pair) to support the front and back of the stick.

The present invention provides, in a third aspect, the component storage stick replacement device according to the first or the second aspect, wherein the another holding unit includes a stopper and a support belt, the stopper being arranged to support the stick at the lowermost tier and arranged to advance and retract by a another drive unit, and the support belt being arranged to rotate and having a projection for supporting the sticks at the second tier and above.

According to the structure described above, the lower side of the sticks at the second tier and above from the bottom is supported (always supported regardless of being supported or unsupported by the holding unit such as the pin) by the projection of the support belt. As the stick is pushed down by the holding unit such as the pin, the support belt is integrally rotated by the pushing force. The stick at the lowermost tier is supported by the advanced (i.e. projected) stopper, released from being supported by the retracting action of the stopper, and moved down one tier integrally with the holding unit such as the pin.

The present invention provides, in a fourth aspect, a method for replacement of component storage stick, including steps of: housing sticks containing components in a frame in a plurality of tiers; holding, by a holding unit, the respective sticks in a plurality of tiers in the frame; characterized in that the method further comprises the steps of supplying the components in the stick at the lowermost tier to a component supply passage; after the stick at the lowermost tier becomes empty, moving the holding unit and the respective sticks in the plurality of tiers down one tier using a lifting-and-lowering unit, thereby positioning the stick at the second tier from the bottom at the component supply passage; supporting the sticks at the second tier and above from the bottom by an another holding unit; releasing the hold of the holding unit by a drive unit, thereby dropping the stick at the lowermost tier to a lower space of the frame; and moving the holding unit up one tier by the lifting-and-lowering unit.

According to the structure described above, the sticks containing the components are housed in the frame in the plurality of tiers, the respective sticks are held in the plurality of tiers in the frame by the holding unit, the component in the stick at the lowermost tier is supplied to the component supply passage, and after (at the time when) the stick at the lowermost tier becomes empty, the respective sticks in the plurality of tiers are moved down one tier together with the holding unit by the lifting-and-lowering unit, and the stick at the second tier from the bottom is positioned at (arranged continue with) the component supply passage so that the component in the stick at the second tier from the bottom can be supplied. The sticks at the second tier and above from the bottom (including the second tier) are supported by the another holding unit, and by releasing the hold of the holding unit by the drive unit, the stick at the lowermost tier drops into the lower space of the frame, and then the holding unit is moved up one tier by the lifting-and-lowering unit and returned to its original position. After that, this cycle is performed until there is no stick with the component (until the stick at the uppermost tier is dropped).

### Advantageous Effects of Invention

According to the invention described in the first aspect, the stick which is finished with supplying the components can be efficiently and rapidly replaced with the stick containing the components, so the components can be supplied continuously and constantly.

According to the invention described in the second aspect, the rotational operation of the shaft can rotate the plurality of pins simultaneously in the direction of holding the stick or in the direction of releasing the stick, thereby downsizing the structure of the device.

According to the invention described in the third aspect, by integrally rotating the support belt by the pushing force of the stick when the stick is moved down, the sticks at the second tier and above can be supported stably by the support belt even when the holding unit such as the pin is released. Furthermore, by supporting the stick at the lowermost tier by the stopper which is capable of advance and retraction, the stick at the lowermost tier which became empty can be dropped into the elimination space in a reliable fashion.

According to the invention described in the fourth aspect, the stick which is finished with supplying the components can be efficiently and rapidly replaced with the stick containing the components, so the components can be supplied continuously and constantly.

### BRIEF DESCRIPTION OF DRAWINGS

Fig. 1 shows one embodiment of a component storage stick replacement device according to the present invention, in which (a) indicates a top view and (b) indicates a side view;
Fig. 2 shows the component storage stick replacement device in a state in which a stick is moved down one tier, in which (a) indicates a top view and (b) indicates a side view;
Fig. 3 shows the component storage stick replacement device in a state in which a stick at a lowermost tier is eliminated, in which (a) indicates a top view and (b) indicates a side view;
Fig. 4 shows the component storage stick replacement device in a state in which a pin for moving down and supporting the stick is moved up one tier, in which (a) indicates a top view and (b) indicates a side view;
Fig. 5 is a side view of one embodiment of a component transport mechanism including a stick and a component supply passage preferable for the component storage stick replacement device;
Fig. 6 is a side view of the component transport mechanism in a state in which the stick at the lowermost tier became empty; and
Fig. 7 is a side view of the component transport mechanism in a state in which the respective sticks are moved down one tier.

### DESCRIPTION OF EXEMPLARY EMBODIMENTS

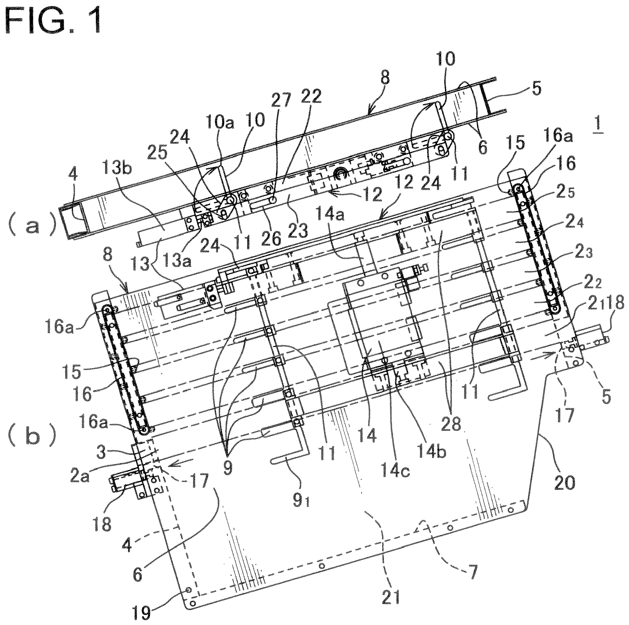

Figs. 1 through 4 show one embodiment of a component storage stick replacement device according to the present invention.

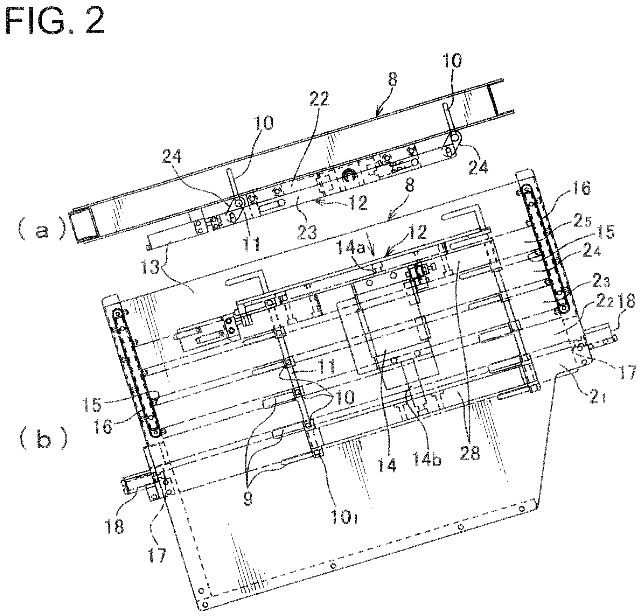

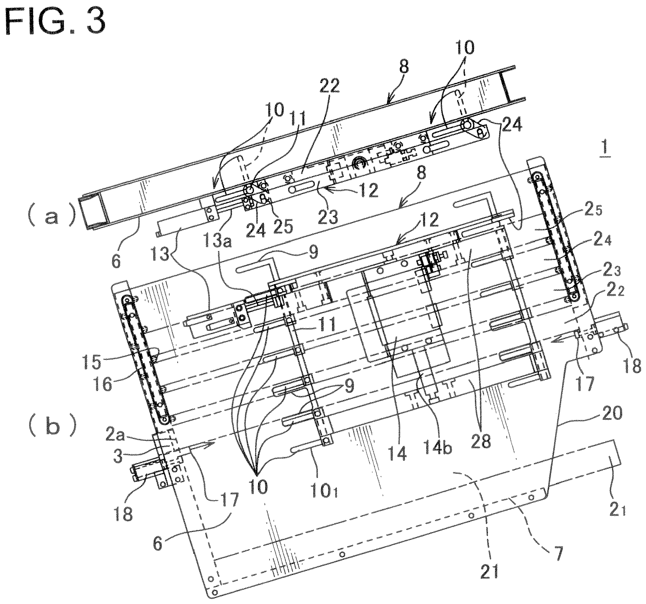

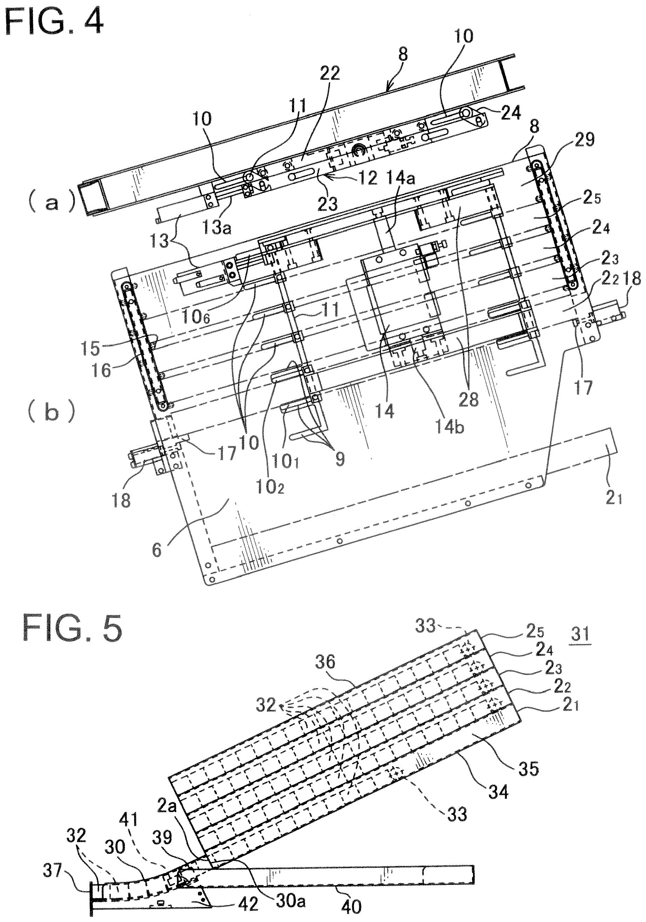

A component storage stick replacement device 1 is arranged such that: rectangular tube-shaped component storage sticks (hereinafter called "sticks") 2 (2₁-2₅) containing components are stacked in a plurality of tiers (five tiers, in this embodiment) (see Fig. 1); once all of the components not shown in the stick 2₁ located at the lowermost tier are supplied and the stick 2₁ became empty, then the respective sticks 2 are simultaneously moved down one tier (see Fig. 2); the stick 2₂ located at the second tier from the bottom and containing the components is positioned at (replaced to) a component supply position 3, and the stick 2₁ located at the lowermost tier which is no longer required is dropped into a lower elimination space (see Fig. 3); and after that, the above-described action is repeated (see Fig. 4) to sequentially supply the components in all of the sticks 2 while eliminating the stick 2 that is no longer required.

As shown in Fig. 1 (a) and (b), the component storage stick replacement device 1 includes: a metallic frame 8 formed into a flat shape and having the inner width slightly wider than the width of the short side of the respective sticks 2 to house the respective sticks 2 in a plurality of tiers, the metallic frame 8 being composed of plate-like front and back walls 4, 5, right and left wide walls (side walls) 6 and a bottom wall 7; respective front and back pins 10 (see Fig. 1 (a)) for supporting and transporting the stick, the pins 10 being arranged in the plurality of tiers for each of the sticks 2 in the plurality of tiers and being arranged to rotate in a lateral direction at an angle of 90 degrees through a slit aperture 9 of the one side wall 6 from outside to inside and then from inside to outside; a front-and-back pair of vertically long shafts (rods) 11 disposed at outside of the one side wall 6 and integrally connecting the respective front and back pins 10 in the plurality of tiers; a parallel link 12 disposed at outside of the one side wall 6 and arranged adjacent to the front and back pins 10 at the uppermost tier to rotate (drive) the respective shafts 11 together with the pins 10; a laterally-arranged air cylinder 13 located at a front side and arranged to drive the parallel link 12 in a front-back direction; a longitudinally-arranged double rod air cylinder 14 fixed to the one side wall 6 and arranged to move the respective shafts 11 up and down with a stroke of one tier of stick; a rotating endless support belt 16 provided to the front and back walls 4, 5 and having a projection 15 which supports a front and back ends of the respective sticks 2₂ to 2₅ at the second tier to the fifth tier from the bottom; and a laterally-arranged air cylinder 18 provided to the front and back walls 4, 5 and having a stopper 17 for supporting the stick 2₁ at the lowermost tier.

The plurality of pins 10 and the shaft 11 constitute a holding unit (a main holding unit), the support belt 16 and the cylinder 18 having the stopper 17 constitute a first and a second another holding units (sub-holding units), the parallel link 12 and the cylinder 13 constitute a drive unit, and the longitudinally-arranged cylinder 14 constitutes a lifting-and-lowering unit.

As shown in Fig. 1 (b), the frame 8 is tilted forward and fixed to a base not shown. Thus, the respective sticks 2 housed in the frame 8 are tilted forward at the same angle as the frame 8. The respective plate-like walls 4 through 7 are fixed to each other by a bolt 19 or a rivet. The front wall 4 extends from the bottom wall 7 at a right angle, and the back wall 5 is arranged shorter than the front wall 4 at upper half side. There is provided an opening 20 for stick elimination located between the bottom wall 7 and a lower end of the back wall 5. A space 21 in the frame located at the front of the opening 20 (a space surrounded by the front wall 4, the bottom wall 7 and the left and right side walls 6) serves as a stick elimination (drop) space. The pin 10 at the lowermost tier and the slit 9 of the one wall 6 through which that pin 10 passes are located above the space 21.

As shown in Fig. 1 (a), the pin 10 projected into the frame 8 is slightly shorter than a gap between the both side walls 6 and is arranged perpendicular to the one side wall 6, and a distal end 10a of the pin 10 is located adjacent to the other side wall 6. The shaft 11 is fixed at a base end of the pin 10. The shaft 11 is arranged to rotate and penetrate through a hole of one (inner) long fixed link (or a link mount base) 22 and fixed to one end of a short link 24. The fixed link 22 functions as a bearing for the shaft 11. The short link 24 connects the shaft 11 and the other (outer) long movable link 23 at a slant, such that a shaft (indicated by the sign 25) of the movable link 24 is movably engaged with a long hole 25 provided at the other end of the short link 24 and extending in a widthwise direction of the link. This is the same for the respective pins 10.

A locating shaft 27 of the fixed link 22 side is slidably engaged with a longitudinal long hole 26 provided to the movable link 23. A rod 13a of the laterally-arranged air cylinder 13 is connected to a front end of the movable link 23, and a main body portion 13b of the air cylinder 13 is fixed to the fixed link (link mount base) 22. The parallel link 12 is constituted of the left-and-right pair of fixed links 22, the movable link 23 and the front-and-back pair of short links 24.

In a state in which the rod 13a of the cylinder 13 is compressed as shown in Fig. 1 (a) and Fig. 2 (a), the pin 10 projects into the frame. In a state in which the rod 13a of the cylinder 13 is extended as shown in Fig. 3 (a) and Fig. 4 (a), the outer movable link 23 moves backward straight with respect to (along) the inner fixed link 22, and the respective short links 24 are rotated backward in a counter-clockwise direction at an angle of 90 degrees around the shaft 11 as a pivot point, and integrally with the respective short links 24, the respective pins 10 are rotated in a counter-clockwise direction at an angle of 90 degrees and moved through the slit 9 of the one side wall 6 to the outside of the frame 8 and positioned in parallel with the fixed link 22. In an alternative embodiment in which the long hole 25 of the short link 24 is omitted, the cylinder 13 needs to be a swing-type since the movable link 23 moves outward away from the fixed link 22.

In Fig. 1 (b), the respective front and back pins 10 are arranged in parallel in total of six tiers so as to contact with the top of each of the five sticks 2 at the uppermost tier through the lowermost tier and with the bottom of the stick 2₁ at the lowermost tier, respectively. As shown in Fig. 3, the pins 10 located at first through third tiers from the bottom are arranged at an equal interval between each other, and the pins 10 located at the fourth through sixth tiers from the bottom are arranged at an equal interval between each other. Referring to Fig. 1 (b), for the slit 9 of the one side wall 6 for passing each of the pins 10, there are provided the slits 9 located correspondingly with the total of six tiers of pins 10, and in addition to these, there is provided one slit 9₁ arranged in parallel and located further one tier below the stick 2₁ at the lowermost tier.

A connection plate 28 is provided in parallel to an upper portion and to a lower portion of the front and back shafts 11. The respective shafts 11 are engaged with the connection plate 28 so as to rotate in a circumferential direction and fixed so as not to move in an axial (up-and-down) direction. Upper and lower rods 14a, 14b of the double rod cylinder 14 are connected to the upper and the lower connection plates 28, and a main body portion 14c of the double rod cylinder 14 is fixed to the one side wall 6 of the frame 8. In Fig. 1 (b), the upper rod 14a is extended and the lower rod 14b is compressed, and the respective connection plates 28 are moved up integrally with the respective rods 14a, 14b, and the respective front and back shafts 11 are moved up integrally with the connection plates 28 and integrally with the pins 10 of the respective tiers. The pin 10 of each tier is in contact with an upper end face of the stick 2 of each tier and with a lower end face of the stick 2₁ at the lowermost tier, and is located adjacent to a lower end face of the sticks 2₂ to 2₅ at the second through fifth tiers (the second tier and above) from the bottom.

The front and back support belts 16 are rotatably arranged between upper and lower rollers 16a. The respective rollers 16a are rotatably and pivotally supported at the left and right side walls 6 at outside of the front and back walls 4, 5 of the frame 8. The support belt 16 includes an endless belt main body (indicated by the reference sign 16), a plurality of projections 15 arranged at an equal interval on an outer face of the belt main body. The respective projections 15 support the lower end face of the front and back ends of the respective sticks 2₂ to 2₅ at the second through fifth tiers from the bottom. The projection 15 is made of synthetic resin or metal and is fixed to the belt main body made of rubber by thread fastening and such.

A lower end face of the stick 2₁ at the lowermost tier is supported by the pin 10₁ at the lower most tier or by the stopper 17 fixed to a distal end of a rod of the front and back air cylinders 18. A main body portion (indicated by the reference sign 18) of the air cylinder 18 is fixed to the left and right side walls 6 at a lower side of the support belt 16 and at outside of the front and back walls 4, 5 of the frame 8.

In Figs. 1 and 2, the rod of the air cylinder 18 is compressed, and the stopper 17 is retracted to outside of the front and back walls 4, 5 to release the support of the stick 2₁ at the lowermost tier, and the stick 2₁ at the lowermost tier is supported only by the pin 10₁. In Fig. 3 and Fig. 4, the pin 10 is moved to the outside of the frame 8 and released from supporting each stick 2, and the rod of the air cylinder 18 is extended so the lower end face of the stick 2₁ at the lowermost tier is supported by the stopper 17.

In the following, the operation of the component storage stick replacement device 1, that is, one embodiment of a method for replacement of component storage stick or a method for supplying components is explained in order of Figs. 1 to 4.

In Fig. 1, the sticks 2 containing the components arranged in five tiers are supported and positioned by the respective projections 15 of the support belts 16, the pin 10₁ at the lowermost tier and the stopper 17 (it is noted that, in a practical way, the pins 10 at the second tier and above are also supporting the sticks 2 at the second tier and above). At a component supply position 3, the component is supplied from a front opening 2a of the stick 2₁ at the lowermost tier to a component supply passage not shown.

At a time when the components in the stick 2₁ at the lowermost tier ran out, as shown in Fig. 2, the stopper 17 is retracted by the compressing action of the rod of the air cylinder 18, and the upper rod 14a of the longitudinally-arranged air cylinder 14 is compressed and the lower rod 14b is extended. Thus, integrally with the connection plates 28, the shafts 11and the pins 10 are moved down one tier in the opened state, and the upper end faces of the sticks 2 at the respective tiers are pushed down by the pins 10 of the respective tiers to move (push) the respective sticks 2 down one tier.

The lower end faces of the sticks 2₁, 2₂ at the lowermost tier and at the second tier from the bottom are supported only by the respective pins 10, and the lower end faces of the sticks 2₃ through 2₅ at the third through fifth tiers from the bottom are supported by the respective projections 15 of the front and back support belts 16 (it is noted that, in a practical way, the pins 10 at the third tier and above are supporting the sticks 2 at the third tier and above). The support belt 16 is arranged to rotate in a direction of the downward movement of the stick (in the drawing, the support belt 16 at the front rotates in a clockwise direction, and the support belt 16 at the back rotates in a counterclockwise direction) integrally with the stick 2 by the pushing force applied to the stick 2 by the pin 10 against the frictional resistance with respect to the roller 16a.

Next, as shown in Fig. 3 (b), the rods of the front and back air cylinders 18 are extended, and the stopper 17 is projected into the frame 8 so as to support the lower end face of the stick 2₂ at the second tier from the bottom. Then, as shown in Fig. 3 (a), the rod 13a of the upper air cylinder 13 is extended, and the parallel link 12 is operated (i.e. the outer movable link 23 is moved backward and the short link 24 is rotated in a counterclockwise direction together with the shaft 11 and the pin 10). Thus, all of the pins 10 are removed (separated) from the one side wall 6 of the frame 8, and thus the stick 2₁ at the lowermost tier in the frame 8 is unsupported and dropped to the lower elimination space 21 and supported by the bottom wall 7 of the frame 8, and a rear end of the stick 2₁ is exposed from the opening 20.

The stick 2₂ at the second tier from the bottom in Fig. 1 is located at the lowermost tier in Fig. 3, and the front opening 2a of the stick 2₂ at the lowermost tier (the second stick) in Fig. 3 is located at the component supply position 3 continuous with a rear opening of the component supply passage not shown, and the components in the stick 2₂ at the lowermost tier (the second stick) in Fig. 3 can be supplied to the component supply passage (it is noted that, the supply of the component may be performed in the state of Fig. 4, or may be performed in a state in which the pin 10 is opened as shown in Fig. 1 from the state shown in Fig. 4).

Next, as shown in Fig. 4 (b), the upper rod 14a of the longitudinally-arranged double rod cylinder 14 is extended and the lower rod 14b is compressed to move each of the upper and lower connection plates 28 up together with the rods 14a, 14b. Thus, together with the connection plates 28, the shafts 11 and the pins 10 are moved up in a closed state. Thus, the pin 10₁ at the lowermost tier is located right beside the lower end face of the stick 2₂ at the lowermost tier (the second stick), the pin 10₂ at the second tier from the bottom is located right beside the upper end face of the stick 2₂ at the lowermost tier (the second stick), the respective pins 10 at the third through fifth tiers from the bottom are located right beside the upper end faces of the respective sticks 2₃ to 2₅ at the second tier (the third stick) through the fourth tier (the fifth stick) from the bottom, and the pin 10₆ at the sixth tier from the bottom is located right beside the upper end face of the imaginary stick at the fifth tier (not shown).

From the state shown in Fig. 4, the rod 13a of the upper front air cylinderl3 is compressed as shown in Fig. 1, by which the pin 10 is opened and projected into the frame 8 by the action of the parallel link 12. At the time when the components in the stick 2₂ at the lowermost tier (the second stick) in Fig. 4 ran out, the stopper 17 is retracted by the compressing action of the air cylinder 18, as shown in Fig. 1, and the rod 14b of the double rod cylinder 14 is extended to move the respective pins 10 down one tier, and at the same time the respective sticks 2 are pushed down as shown in Fig. 2. Then, the stopper 17 is projected by the extending action of the air cylinder 18 to hold the third stick 2₃. Then, the rod 13a of the upper front air cylinder 13 is extended, and by the movement of the parallel link 12, the pin 10 is closed and moved to the outside of the frame 8, by which the stick 2₂ at the lowermost tier (the second stick) is dropped. Then, as shown in Fig. 4, the respective pins 10 in the closed state are moved up by the extending action of the upper rod 14a of the double rod cylinder 14, and the rod 13a of the upper front air cylinder 13 is compressed, and the pin 10 is opened and projected into the frame 8 by the movement of the parallel link 12.

After that, this cycle (i.e. the cycle including the retraction of the stopper 17→ the downward movement of the respective sticks 2 by the pin 10 and the cylinder 14→ the projection of the stopper 17→the removal of the pin 10 to the outside by the cylinder 13→the upward movement of the pin 10 by the cylinder 14→inward projection of the pin 10 by the cylinder 13) is repeated to supply the component to the component supply passage until the stick 2₅ at the uppermost tier is positioned at the lowermost tier and the components in the stick 2₅ run out.

Once all of the sticks 2 are eliminated, new sticks 2 containing the components are installed in the plurality of tiers to continue the supply of the components. It is possible to install a new stick 2 containing the components to an empty space at the uppermost tier shown in Fig. 4. In this case, the next step in the process in Fig. 4 becomes (returns to) the step shown in Fig. 1.

The above-described component storage stick replacement device 1 may be applied with a component transport mechanism 31 including a stick 2 and a component supply passage 30 shown in Figs. 5 to 7. The device 1 shown in Figs. 1 through 4 including the mechanism 31 shown in Figs. 5 to 7 may also be called the component supply device. In the following, a method for replacement of component storage stick or a method for supplying components is explained.

A component 32 according to this embodiment is a connector housing made of an insulating resin. The plurality of components 32 are housed in sticks 2 (2₁ to 2₅) at the respective tiers in tandem, and a weight ball 33 made of metal is disposed on the tail end of the connector housings 32. Thus, the connector housing 32 slides down smoothly in the forward-tilted stick 2 due to the own weight of the connector housing 32 and the own weight of the weight ball 33. The weight ball 33 is not required if the predetermined angle of the tilt is steep.

The stick 2 is formed into a substantially rectangular tube-like shape with a bottom wall 34, right and left walls 35 and an upper wall 36 according to the shape of the connector housing 32. The front opening 2a of the stick 2₁ at the lowermost tier is formed continuous with a rear opening 30a of the component supply passage 30 having a groove-like shape (a gutter-like shape). A stop wall 37 is vertically-arranged at a front end of the forward-tilted (curved) component supply passage 30, and the connector housing 32 which abuts on the stop wall 37 is transported by a chuck not shown to a next step which is a terminal insertion step.

The component supply passage 30 includes an aperture 39 through which the weight ball 33 is eliminated. The aperture 39 is communicated with a rearward-tilted weight ball collection passage 40. A proximity sensor (sensor) 41 for the detection of weight ball is provided in the weight ball collection passage 40 at a location adjacent to (at the front of) the aperture 39. The component supply passage 30 and the weight ball collection passage 40 are fixed to a frame base 42.

By detecting the weight ball 33 using the sensor 41, it is detected that the stick 2₁ at the lowermost tier became empty, and a signal indicating that is transmitted to a control unit not shown, thereby sequentially-performing the actions such as driving the double rod cylinder 14 as shown in Fig. 2 (pushing down the stick 2 by the downward movement of the pin 10), driving the lower front and back air cylinders 18 as shown in Fig. 3 (supporting the stick 2₂ at the second tier from the bottom by advancing the stopper 7), and eliminating the stick 2₁ at the lowermost tier by driving the upper front air cylinder 13 (closing the pin 10 by the parallel link 12) as shown in Fig. 3.

In Fig. 5, the proximity sensor 41 may be replaced with a phototube sensor or a lever-type sensor or the like. In case the weight ball 33 is not used, it is possible, for example, to apply a light sensor for detecting the existence or absence of the connector housing 32 at the front end of the stick 2₁ at the lowermost tier.

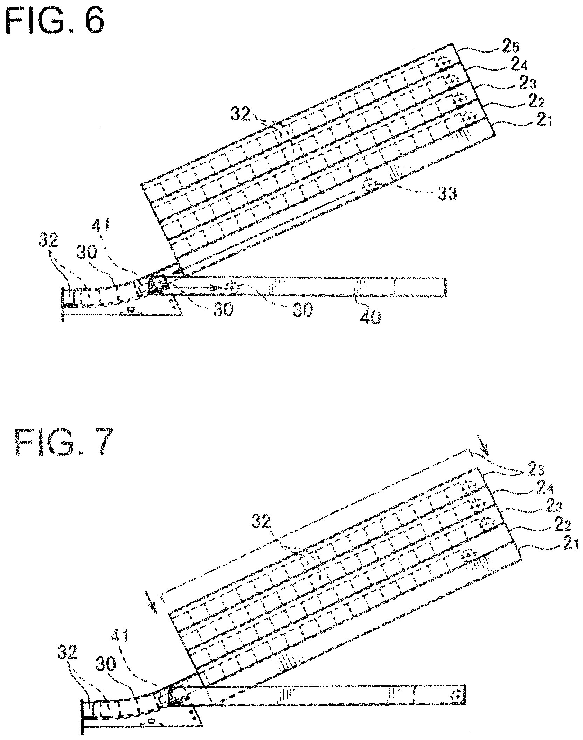

Fig. 5 corresponds to Fig. 1, Fig. 6 corresponds to a state of Fig. 1 in which the stick 2₁ at the lowermost tier is empty, and Fig. 7 corresponds to Fig. 2. That is, in Fig. 1, when the stick 2₁ at the lowermost tier in Fig. 5 became empty (to be precise, this is when the stick 2₁ at the lowermost tier became empty and there is no connector housing 32 between the front end 2a of the stick 2₁ at the lowermost tier and the aperture 39 of the component supply passage 30), then the weight ball 33 in the stick 2₁ at the lowermost tier is dropped from the aperture 39 to the weight ball collection passage 40 and at the same time detected by the proximity sensor 41, thereby performing the actions such as pushing the stick 2 down by the pin 10 shown in Fig. 2, supporting the stick 2₂ at the second tier from the bottom by the stopper 17 of the lower air cylinder 18 shown in Fig. 3, eliminating the stick 2₁ at the lowermost tier by closing the pin 10 shown in Fig. 3, and moving the closed pin 10 up as shown in Fig. 4.

Since the weight ball 33 is housed in the sticks 2₂ to 2₅ at the second tier and above, when the stick 2₂ at the second tier from the bottom is moved to the lowermost tier and located continuous with the component supply passage 30, the action of detecting whether or not the stick 2₂ at the second tier from the bottom is empty and the action of removal of the stick 2₂, as well as the action of replacement of the stick 2₂ at the second tier from the bottom with the stick 2₃ at the third tier from the bottom, are automatically performed sequentially by the same operation as described above.

In the above-described embodiment (Fig. 5), the connector housing 32 is used as the component; however, in place of the connector housing 32, a connector which houses an electric wire crimping terminal or a relay or a box-shaped fusible link or the like may be used as the component, for example.

Furthermore, in the above-described embodiment (Fig. 1), the double rod cylinder 14 is used to simultaneously move the upper and lower connection plates 28 up and down; however, it is possible to use a single rod cylinder and one of the upper and lower connection plates 28 to move the one of the upper and lower connection plates 28 up and down. Furthermore, the cylinder 18 with the stopper 17 may be replaced with a solenoid with a stopper.

Moreover, in the above-described embodiment (Fig. 1), the lower face (the bottom face) of the stick 2 is supported mainly by the projection 15 of the support belt 16, and the upper face of the stick 2 is pushed down by the pin 10 to rotate the support belt 16; however, for example, the support belt 16 may be eliminated (omitted), and the lower face and the upper face of the sticks 2 in the respective tiers may be supported only by the pins 10 in the respective tiers to push down and support the stick 2 using the pin 10. In the case of using the front and back support belts 16 as shown in Fig. 1, it is possible to dispose a single pin 10 at a center instead of at the front and back. In this case, the pin 10 is arranged so as not to interfere with the double rod cylinder 14.

Furthermore, in the above-described embodiment, all of the pins 10 are opened and closed (projected and housed) by the parallel link 12; however, the respective pins 10 may be replaced with rods of respective solenoids, and a solenoid main body may be connected using a vertically-arranged connection plate (not shown), and this connection plate can be moved up and down using the double rod cylinder 14. Furthermore, the shaft 11 connecting the respective pins 10 may be connected to a rotatable air cylinder (actuator) and such to open and close the pin 10.

Moreover, in the above-described embodiment, the device 1 and the stick 2 are integrally tilted forward and the component 32 is slidably supplied along the stick 2 at least by the own weight of the component 32; however, for example, in the case of supplying the component 32 along the stick 2 by air pressure, the device 1 may be arranged horizontally instead of being tilted in use.

### INDUSTRIAL APPLICABILITY

The component storage stick replacement device and a method for replacement of component storage stick according to the present invention can be utilized for producing a connector as a part of a wire harness, by storing a connector housing and such as a component into sticks arranged in a plurality of tiers, and sequentially supplying the connector housing from the stick at the lowermost tier to the next step which is a step of insertion of a terminal with an electric wire.

### REFERENCE SIGN LIST

1 component storage stick replacement device
2 stick
2₁ stick at the lowermost tier
22 stick at the second tier from the bottom
2₂-2₅ sticks at the tiers other than the lowermost tier (sticks at the second tier and above)
8 frame
10 pin (holding unit)
11 shaft (holding unit)
12 parallel link (drive unit)
13 air cylinder (drive unit)
14 air cylinder (lifting-and-lowering unit)
15 projection (another holding unit)
16 support belt (another holding unit)
17 stopper (another holding unit)
18 air cylinder (another drive unit)
21 lower space
22 fixed link (link mount base)
23 movable link
24 short link
30 component supply passage
32 connector housing (component)

## Claims

1. A component storage stick replacement device (1) comprising:
a frame (8) arranged to house a plurality of tiers of sticks (2) containing components and having an empty stick elimination space located at a lower portion of the frame;
a holding unit (10, 11) arranged to hold the respective sticks in a plurality of tiers within the frame;
**characterized in that**
a lifting-and-lowering unit (14) is arranged to move the respective sticks in the plurality of tiers down one tier together with the holding unit and to move the holding unit up one tier separately from the respective sticks to return the holding unit to an original position;
a drive unit (12, 13) is arranged to operate the holding unit to hold and release the respective sticks; and
an another holding unit is arranged to hold the sticks other than the stick at the lowermost tier (2₁) at least during the release.

2. The component storage stick replacement device according to claim 1, wherein the holding unit is a plurality of laterally-arranged pins fixed to a longitudinally-arranged shaft and arranged on top and bottom of each of the sticks, the shaft being arranged to rotate together with the respective pins by the drive unit.

3. The component storage stick replacement device according to claim 1 or 2, wherein the another holding unit includes a stopper (17) and a support belt (16), the stopper being arranged to support the stick at the lowermost tier (2₁) and arranged to advance and retract by a another drive unit, and the support belt being arranged to rotate and having a projection for supporting the sticks at the second tier and above.

4. A method for replacement of component storage stick, the method comprising steps of:
housing sticks (2, 2₁, 2₂) containing components in a frame (8) in a plurality of tiers;
holding, by a holding unit (10, 11), the respective sticks in a plurality of tiers in the frame;
**characterized in that** the method further comprises the steps of:
supplying the components in the stick at the lowermost tier (2₁) to a component supply passage;
after the stick at the lowermost tier (2₁) becomes empty, moving the holding unit and the respective sticks in the plurality of tiers down one tier using a lifting-and-lowering unit(14), thereby positioning the stick at the second tier from the bottom (2₂) at the component supply passage (30);
supporting the sticks at the second tier and above (2₂ - 2₅) from the bottom by an another holding unit;
releasing the hold of the holding unit by a drive unit (12, 13), thereby dropping the stick at the lowermost tier (2₁) to a lower space (21) of the frame; and
moving the holding unit up one tier by the lifting-and-lowering unit.

## Patentansprüche

1. Vorrichtung zum Ersetzen eines Komponentenaufbewahrungsstabs (1), umfassend:
einen Rahmen (8), der so angeordnet ist, dass er mehrere Lagen von Stäben (2) aufnimmt, die Komponenten enthalten und einen Entleerungsraum für leere Stäbe aufweisen, der an einem unteren Abschnitt des Rahmens angeordnet ist;
eine Halteeinheit (10, 11), die angeordnet ist, um die jeweiligen Stäbe in einer Vielzahl von Lagen innerhalb des Rahmens zu halten;
**dadurch gekennzeichnet, dass**
eine Hebe- und Absenkeinheit (14) angeordnet ist, um die jeweiligen Stäbe in der Vielzahl von Lagen zusammen mit der Halteeinheit um eine Lage nach unten zu bewegen und die Halteeinheit um eine Lage, getrennt von den jeweiligen Stäben, nach oben zu bewegen, um die Halteeinheit in eine Ursprungsposition zurückzuführen;
eine Antriebseinheit (12, 13) angeordnet ist, um die Halteeinheit zu betätigen, um die jeweiligen Stäbe zu halten und freizugeben; und
eine weitere Halteeinheit angeordnet ist, um die Stäbe mit Ausnahme des Stabs in der untersten Lage (2₁) zumindest während der Freigabe zu halten.

2. Vorrichtung zum Ersetzen eines Komponentenaufbewahrungsstabs nach Anspruch 1, wobei die Halteeinheit eine Vielzahl von seitlich angeordneten Stiften ist, die an einer in Längsrichtung angeordneten Welle befestigt sind und oben und unten an jedem der Stäbe angeordnet sind, wobei die Welle so angeordnet ist, dass sie sich zusammen mit den jeweiligen Stiften durch die Antriebseinheit dreht.

3. Vorrichtung zum Ersetzen eines Komponentenaufbewahrungsstabs nach Anspruch 1 oder 2, wobei die weitere Halteeinheit einen Stopper (17) und ein Stützband (16) umfasst, wobei der Stopper so angeordnet ist, dass er den Stift in der untersten Lage (2₁) hält und von einer anderen Antriebseinheit vor- und zurückbewegt wird, und wobei das Stützband so angeordnet ist, dass es sich dreht und einen Vorsprung aufweist, um die Stäbe in der zweiten Lage und darüber zu halten.

4. Verfahren zum Ersetzen eines Komponentenaufbewahrungsstabs, wobei das Verfahren die folgenden Schritte umfasst:
Anordnen von Stäben (2, 2₁, 2₂), die in mehreren Lagen Komponenten in einem Rahmen (8) enthalten;
Halten, durch eine Halteeinheit (10, 11), der jeweiligen Stäbe in mehreren Lagen im Rahmen;
**dadurch gekennzeichnet, dass** das Verfahren ferner die folgenden Schritte umfasst:
Zuführen der Komponenten in den Stab in der untersten Lage (2₁) zu einem Komponentenzufuhrkanal;
nachdem der Stab in der untersten Lage (2₁) leer geworden ist, Bewegen der Halteeinheit und der jeweiligen Stäbe in der Vielzahl von Lagen um eine Lage unter Verwendung einer Hebe- und Absenkeinheit (14) nach unten zu bewegen, um dadurch den Stab in der zweiten Lage von unten (2₂) in dem Komponentenzufuhrkanal (30) anzuordnen;
Halten der Stäbe in der zweiten Lage und darüber (2₂ - 2₅) von unten durch eine weitere Halteeinheit;
Lösen der Halterung der Halteeinheit durch eine Antriebseinheit (12, 13), so dass der Stab in der untersten Lage (2₁) in einen unteren Raum (21) des Rahmens fällt; und
Bewegen der Halteeinheit durch die Hebe- und Absenkeinheit um eine Lage nach oben.

## Revendications

1. Dispositif de remplacement de baguette de stockage de composants (1) comprenant :
un châssis (8) agencé pour loger une pluralité de niveaux de baguettes (2) contenant des composants et comportant un espace d'élimination des baguettes vides situé au niveau de la partie inférieure du châssis,
une unité de support (10, 11) disposée pour supporter les baguettes respectives dans une pluralité de niveaux à l'intérieur du châssis,
**caractérisé en ce que**
une unité de levée et d'abaissement (14) est agencée pour déplacer les baguettes respectives dans la pluralité de niveaux d'un niveau vers le bas en même temps que l'unité de support et pour déplacer l'unité de support d'un niveau vers le haut séparément des baguettes respectives pour faire revenir l'unité de support à sa position d'origine,
une unité d'entraînement (12, 13) est agencée pour manoeuvrer l'unité de support pour qu'elle maintienne et libère les baguettes respectives, et
une autre unité de support est agencée pour supporter les baguettes différentes de ladite baguette située au niveau (2₁) le plus bas au moins pendant la libération.

2. Dispositif de remplacement de baguette de stockage de composants selon la revendication 1, dans lequel l'unité de support est une pluralité de broches agencées latéralement et fixées à un arbre agencé longitudinalement et agencé au sommet et à la base de chacune des baguettes, l'arbre étant disposé pour tourner en même temps que les broches respectives grâce à l'unité d'entraînement.

3. Dispositif de remplacement de baguette de stockage de composants selon la revendication 1 ou la revendication 2, dans lequel l'autre unité de support inclut une butée (17) et une courroie de support (16), la butée étant agencée pour supporter la baguette située au niveau (2₁) le plus bas et agencée pour avancer et reculer grâce à une autre unité d'entraînement, et la courroie de support étant agencée pour tourner et comportant une protubérance permettant de supporter les baguettes au second niveau et au-dessus.

4. Procédé de remplacement d'une baguette de stockage de composants, le procédé comprenant les étapes suivantes :
loger sur une pluralité de niveaux des baguettes (2, 2₁, 2₂) contenant des composants dans un châssis (8),
supporter, grâce à une unité de support (10, 11), les baguettes respectives sur une pluralité de niveaux dans le châssis,
**caractérisé en ce que** le procédé comprend en outre les étapes suivantes :
la délivrance des composants dans la baguette située au niveau (2₁) le plus bas à un passage de fourniture de composants,
après que la baguette située au niveau (2₁) le plus bas s'est vidée, le déplacement de l'unité de support et des baguettes respectives sur la pluralité de niveaux d'un niveau vers le bas en utilisant une unité de levée et d'abaissement (14), ce qui positionne ainsi la baguette au deuxième niveau à partir du bas (2₂) au niveau du passage de fourniture de composants (30),
le support des baguettes au second niveau et au-dessus (2₂ à 2₅) depuis le bas grâce à une autre unité de support,
la libération du support de l'unité de support grâce à une unité d'entraînement (12, 13), ce qui fait chuter ainsi la baguette au niveau (2₁) le plus bas vers un espace inférieur (21) du châssis, et
le déplacement de l'unité de support d'un niveau vers le haut grâce à l'unité de levée et d'abaissement.
